# EUROPEAN PATENT APPLICATION

(11) **EP 4 682 926 A1**
(43) Date of publication of application: **21.01.2026**
(21) Application number: 24770887.8
(22) Date of filing: 12.03.2024
(51) Int. Cl.: H01H 36/00, G01R 33/07

(54) **SWITCH**

(30) Priority: 13.03.2023 JP 2023038946
(71) Applicant: OMRON Corporation, Kyoto 600-8530 (JP)
(72) Inventor: MURAKAMI, Kohei, Kyoto-shi, Kyoto 600-8530 (JP); SU, Rina, Kyoto-shi, Kyoto 600-8530 (JP); TANAKA, Junji, Kyoto-shi, Kyoto 600-8530 (JP)
(74) Representative: HGF
(86) International application number: PCT/JP2024/009570
(87) International publication number: WO 2024/190782

(57) **Abstract**

A switch according to the present disclosure includes a main body and an actuator that is capable of being disposed at a detection position that the actuator is close to the main body and faces the main body. The actuator includes a first magnet, a second magnet, a third magnet, and a fourth magnet arranged in order along a second direction intersecting a first direction that is a facing direction of the main body and the actuator when the actuator is located at the detection position. Each magnet is arranged such that one magnetic pole and another magnetic pole are arranged along the first direction, and that an arrangement of the magnetic poles in the first direction is different from that of an adjacent magnet. The main body includes three or more sensors configured to be able to detect a magnetic flux generated by at least one of the first to the fourth magnet. Three or more of the sensors are arranged along the second direction. When the actuator is located at the detection position, a center of at least one of three or more of the sensors in the second direction is located at a position deviating in the second direction from a center of each of the first to the fourth magnet in the second direction.

## Description

### TECHNICAL FIELD

The present disclosure relates to a switch that detects the proximity of a main body and an actuator.

### BACKGROUND ART

As this type of switch, for example, one described in Patent Document 1 has conventionally been known. The switch described in Patent Document 1 includes a main body, and an actuator that is capable of approaching and facing the main body.

The actuator includes three magnets, namely, a first magnet, a second magnet, and a third magnet. The first magnet, the second magnet, and the third magnet are arranged in order in a lateral direction (second direction) intersecting a facing direction (first direction) of the main body and the actuator being close to the main body. The magnets are each arranged such that one magnetic pole and the other magnetic pole are arranged along the facing direction, and that the arrangement of the magnetic poles in the facing direction is different from that of an adjacent magnet.

The main body includes three or more sensors different in number of the magnets. Each of the sensors outputs a detection signal when the main body and the actuator come into proximity and the sensor detects a magnetic flux generated by at least one of the three magnets.

When the detection signals are output from all the sensors, the main body outputs a proximity signal corresponding to a state in which the main body and the actuator are close. When no detection signal is output from at least one sensor, the main body outputs a separation signal corresponding to a state in which the main body and the actuator are spaced apart.

### PRIOR ART DOCUMENT

### PATENT DOCUMENT

Patent Document 1: Japanese Patent No. 4321611

### SUMMARY OF THE INVENTION

### PROBLEMS TO BE SOLVED BY THE INVENTION

The switch of Patent Document 1 still has room for improvement from the standpoint of restraining both an increase in size of the actuator and a deterioration in detection accuracy.

Thus, an object of the present disclosure is to solve the above problems, and to provide a switch with both the increase in size of the actuator and the deterioration in detection accuracy restrained.

### SOLUTIONS TO THE PROBLEMS

A switch according to the present disclosure includes:
a main body; and
an actuator that is capable of being disposed at a detection position that the actuator is close to the main body and faces the main body, in which
the actuator includes a first magnet, a second magnet, a third magnet, and a fourth magnet,
the first magnet, the second magnet, the third magnet, and the fourth magnet are arranged in order along a second direction intersecting a first direction that is a facing direction of the main body and the actuator when the actuator is located at the detection position,
the first magnet, the second magnet, the third magnet, and the fourth magnet are each arranged such that one magnetic pole and another magnetic pole are arranged along the first direction, and that an arrangement of the magnetic poles in the first direction is different from that of an adjacent magnet,
the main body includes three or more sensors configured to be able to detect a magnetic flux generated by at least one of the first magnet, the second magnet, the third magnet, and the fourth magnet,
three or more of the sensors are arranged along the second direction, and
when the actuator is located at the detection position, a center of at least one of three or more of the sensors in the second direction is located at a position deviating in the second direction from a center of each of the first magnet, the second magnet, the third magnet, and the fourth magnet in the second direction.

### EFFECTS OF THE INVENTION

According to the present disclosure, it is possible to provide the switch with both the increase in size of the actuator and the deterioration in detection accuracy restrained.

### BRIEF DESCRIPTION OF THE DRAWINGS

[Fig. 1] Fig. 1 is a perspective view of a switch according to an embodiment of the present disclosure.
[Fig. 2] Fig. 2 is a sectional view of the switch of Fig. 1, taken along line II-II.
[Fig. 3] Fig. 3 is a sectional view corresponding to Fig. 2, showing a modification of the switch of Fig. 1.

### DETAILED DESCRIPTION

### <Findings Underlying Present Disclosure>

The present inventors have advanced development of a switch in which a fourth magnet is further provided in an actuator in order to further reduce the possibility of nullification in the switch. The nullification here means that, although a main body and the actuator are actually spaced apart, a proximity signal is erroneously output from the main body due to an object other than the actuator approaching the main body. The object generates a magnetic field analogous to a magnetic field generated around the actuator.

When four magnets, namely, first to fourth magnets are arranged and arranged in the actuator in order in a second direction, it is conceivable to make each of the first to fourth magnets smaller than conventional ones in order to restrain an increase in size of the actuator. However, when the first to fourth magnets smaller than conventional ones are arranged, magnetic fluxes emitted or absorbed by the respective magnets are weakened, so that detection accuracy of the switch is likely to deteriorate.

It is also conceivable to make intervals between the magnets smaller than those in conventional switches so that the increase in size of the actuator is restrained. However, when the intervals are smaller, the magnetic flux emitted or absorbed by each of the second magnet and the third magnet possibly interferes with the magnetic flux, opposite in direction, emitted or absorbed by each of the first magnet and the fourth magnet adjacent to the second magnet and the third magnet. As a result of this interference, a reaching distance of the magnetic flux emitted or absorbed by each of the second magnet and the third magnet is likely to decrease. In other words, when the main body and the actuator come into proximity, the magnetic flux density is likely to decrease at a position at which the main body is disposed. This raises the possibility that, although the main body and the actuator are close, sensors of the main body cannot sufficiently detect the magnetic fluxes generated by the four magnets, and the proximity signal is not output from the switch. That is, the possibility that the detection accuracy of the switch deteriorates, arises.

Therefore, the present inventors have intensively studied the magnetic fields generated by the four magnets provided in the actuator. As a result, the finding has been discovered that, when the main body and the actuator come into proximity, the magnetic flux density increases at a position facing a position deviating from each of the centers of the second magnet and the third magnet in the second direction, relative to a position facing a position coinciding with the center of each of the magnets.

Based on this finding, the present inventors have thought of disposing at least one of the sensors such that the center of the one sensor in the second direction is set to a position deviating in the second direction from the center of each of the four magnets in the second direction. With this arrangement, at least one sensor can be disposed at a position with a high magnetic flux density, as compared with a configuration in which the sensors are arranged such that the centers of all of the sensors in the second direction coincide with the centers of the respective magnets in the second direction. As a result, when the main body and the actuator come into proximity, the magnetic fluxes emitted or absorbed by the second magnet and the third magnet can be further reliably detected. Based on these novel findings, the present inventors have arrived at the present disclosure.

Hereinafter, embodiments of the present disclosure will be described with reference to the drawings. In the following description, terms (for example, terms including "up", "down", "right", and "left") denoting specific directions or positions are used as necessary; however, the use of these terms is to facilitate understanding of the present disclosure by reference to the drawings, and the technical scope of the present disclosure is not limited by the meanings of these terms. In addition, the following description is merely exemplary in nature and is not intended to limit the present disclosure, applications thereof, and uses thereof.

In the present specification, "electrically connected" includes all the following: a current can be caused to flow through a plurality of components; a plurality of components are capacitively coupled; and a plurality of components are electromagnetically coupled.

### <Embodiment>

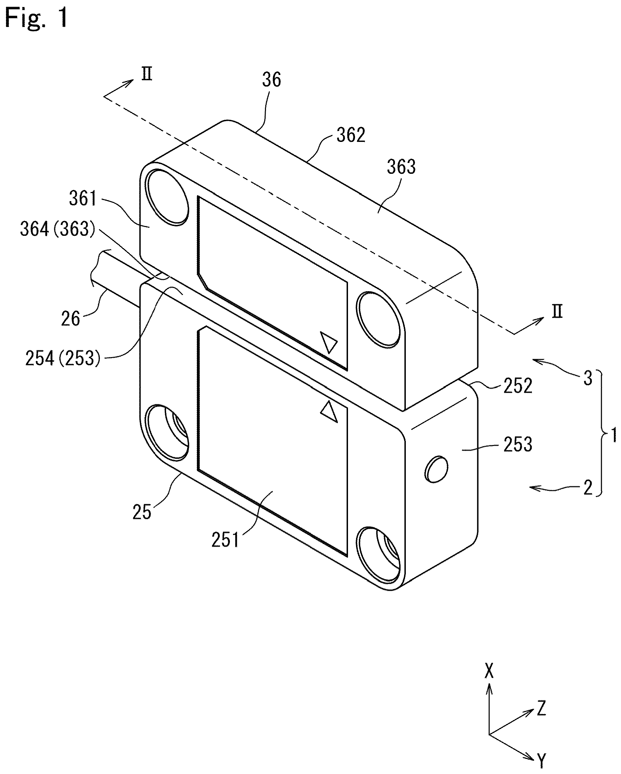

A switch according to an embodiment of the present disclosure will be described with reference to Fig. 1. Fig. 1 is a perspective view of the switch according to the embodiment of the present disclosure. In the present embodiment, the switch is a non-contact door switch that detects open and closed states of a door or the like.

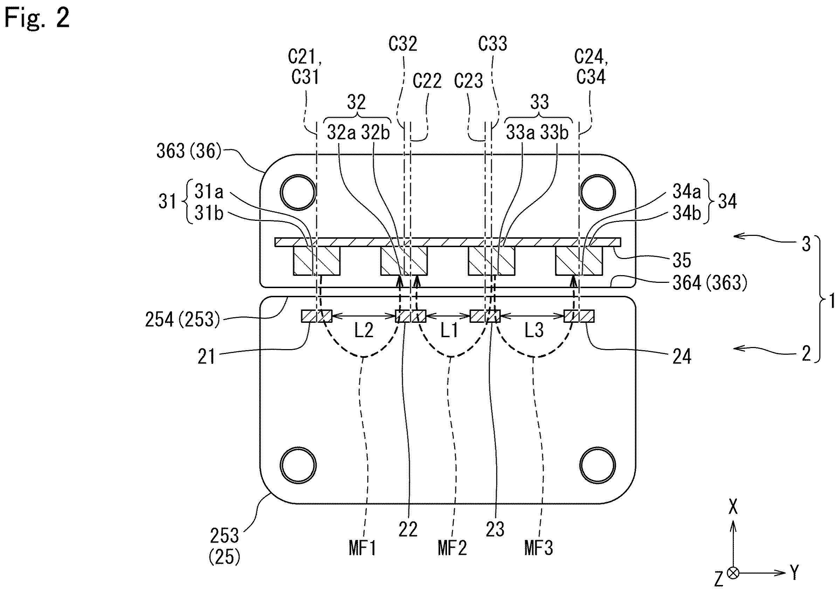

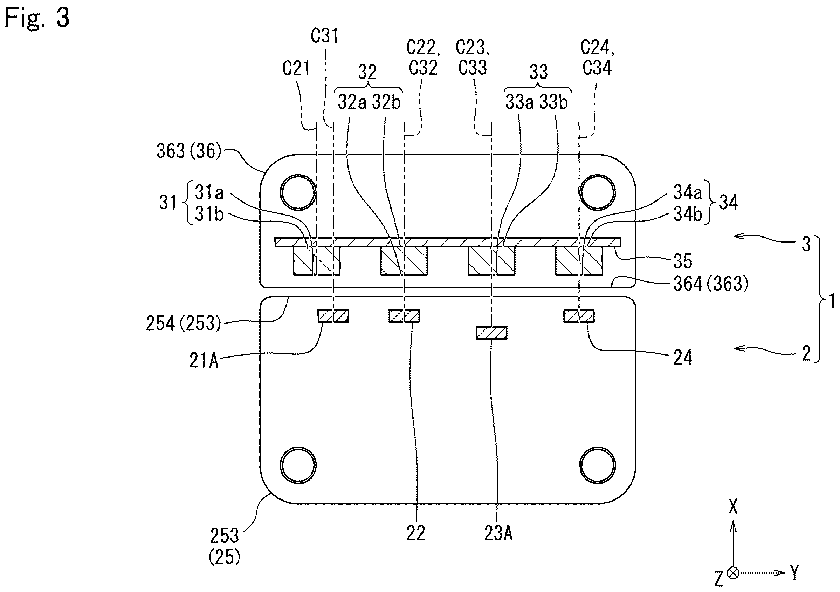

In Fig. 1 and the later-described Figs. 2 and 3, an X axis, a Y axis, and a Z axis intersecting with one another are denoted for convenience of description. In the present embodiment, the X axis, the Y axis, and the Z axis are orthogonal to one another. In the present specification and claims, "intersect" is not limited to being orthogonal, and indicates that two or more members, virtual axes, and the like intersect. That is, "intersect" also includes the meaning that two or more members, virtual axes, and the like are substantially orthogonal.

As shown in Fig. 1, a switch 1 according to the present embodiment includes a main body 2, and an actuator 3 that is capable of being disposed at a detection position that the actuator 3 is close to the main body 2 and faces the main body 2. Fig. 1 and the later-described Figs. 2 and 3 show a state in which the actuator 3 is located at the detection position that the actuator 3 is close to the main body 2 and faces the main body 2 in an X direction. The X direction is an example of a "first direction" in the present disclosure. In the following description regarding the actuator 3, unless otherwise specified, the terms, such as the X axis, the Y axis, and the Z axis, are used on the assumption that the actuator 3 is located at the detection position.

In the present embodiment, the main body 2 is attached to a fixed body provided around the door of which the open and closed states are detected, and the actuator 3 is attached to the door itself. More specifically, the actuator 3 is attached so as to be close to and face the main body 2 when the door is closed, and, on the other hand, be at a position that is spaced apart from the main body 2 and does not face the main body 2 when the door is opened.

Fig. 2 is a sectional view of the switch of Fig. 1, taken along the line II-II. As shown in Fig. 2, the actuator 3 includes four magnets 31 to 34, a magnetic body 35, and a casing 36 that houses the four magnets 31 to 34 and the magnetic body 35. In the present embodiment, the four magnets include a first magnet 31, a second magnet 32, a third magnet 33, and a fourth magnet 34.

In the present embodiment, the casing 36 has a substantially rectangular parallelepiped shape elongated in a Y direction as shown in Fig. 1. The casing 36 has an upper wall 361 and a lower wall 362 that face each other in a Z direction, and a peripheral wall 363. The peripheral wall 363 connects the edge of the upper wall 361 and the edge of the lower wall 362 along the Z direction. A portion of the peripheral wall 363 facing the main body 2 in the X direction constitutes a facing wall 364.

As shown in Fig. 2, the four magnets 31 to 34 and the magnetic body 35 are housed in the casing 36. The first magnet 31, the second magnet 32, the third magnet 33, and the fourth magnet 34 are arranged in order along the Y direction intersecting the first direction (X direction) that is a facing direction of the main body 2 and the actuator 3. The Y direction is an example of a "second direction" in the present disclosure. In the present embodiment, the first magnet 31, the second magnet 32, the third magnet 33, and the fourth magnet 34 are arranged in order in a positive direction of the Y axis (rightward in Fig. 2) along the facing wall 364.

Of the four magnets 31 to 34, two magnets (each pair of the first magnet 31 and the second magnet 32, the second magnet 32 and the third magnet 33, and the third magnet 33 and the fourth magnet 34) adjacent in the Y direction, at least partially face in the Y direction. Centers of the magnets 31 to 34 in the X direction may be located at the same position in the X direction, or may be located at different positions. In the present embodiment, the centers of the respective magnets 31 to 34 in the X direction are located at the same position in the X direction.

Among the four magnets 31 to 34, intervals in the Y direction each between two magnets adjacent in the Y direction may be the same or different. In the present embodiment, in the Y direction, an interval between the first magnet 31 and the second magnet 32, an interval between the second magnet 32 and the third magnet 33, and an interval between the third magnet 33 and the fourth magnet 34, are the same.

The shapes, types, and magnetic forces of the four magnets 31 to 34 may be similar or different. In the present embodiment, the four magnets 31 to 34 are the same type of magnets, and have the same shape and magnetic force.

The magnetic body 35 is disposed so as to face the facing wall 364 in the X direction with the four magnets 31 to 34 interposed therebetween in plan view seen along the Z axis. The magnetic body 35 restrains the magnetic fluxes generated by the four magnets 31 to 34 from being emitted in a positive direction of the X axis, and enhances the emission in a negative direction of the X axis. For example, the magnetic body 35 has a shape along the arrangement of the magnets 31 to 34 in the X direction. In the present embodiment, the magnetic body 35 has a flat plate shape substantially orthogonal to the X axis, and is in contact with the four magnets 31 to 34.

The magnets 31 to 34 include one magnetic poles 31a, 32a, 33a, and 34a that are arranged along the X direction, and the other magnetic poles 31b, 32b, 33b, and 34b, respectively. The one magnetic poles 31a, 32a, 33a, and 34a face the main body 2 in the X direction. That is, the one magnetic poles 31a, 32a, 33a, and 34a face the facing wall 364 in the X direction. On the other hand, the other magnetic poles 31b, 32b, 33b, and 34b face the magnetic body 35 in the X direction.

The magnets 31 to 34 are arranged such that the arrangement of the magnetic poles in the X direction is different from those of the adjacent magnets. In the present embodiment, the one magnetic poles 31a and 33a of the first magnet 31 and the third magnet 33, and the other magnetic poles 32b and 34b of the second magnet 32 and the fourth magnet 34 are N poles. The other magnetic poles 31b and 33b of the first magnet 31 and the third magnet 33, and the one magnetic poles 32a and 34a of the second magnet 32 and the fourth magnet 34 are S poles.

In Fig. 2, a first magnetic flux MF1, a second magnetic flux MF2, and a third magnetic flux MF3 that are generated by the four magnets 31 to 34 and directed to the main body 2 are schematically shown by the broken lines. The first magnetic flux MF1 is emitted from the one magnetic pole 31a (N pole) of the first magnet 31, and converges on the one magnetic pole 32a (S pole) of the second magnet 32. The second magnetic flux MF2 is emitted from the one magnetic pole 33a (N pole) of the third magnet 33, and converges on the one magnetic pole 32a (S pole) of the second magnet 32. The third magnetic flux MF3 is emitted from the one magnetic pole 33a (N pole) of the third magnet 33, and converges on the one magnetic pole 34a (S pole) of the fourth magnet 34.

The main body 2 includes three or more sensors 21 to 24, and a casing 25 that houses the sensors 21 to 24. In the present embodiment, the casing 25 of the main body 2 has a substantially rectangular parallelepiped shape elongated in the Y direction. The casing 25 has an upper wall 251 and a lower wall 252 that face each other in the Z direction, and a peripheral wall 253. The peripheral wall 253 connects the edge of the upper wall 251 and the edge of the lower wall 252 in the Z direction. The peripheral wall 253 has a facing wall 254 facing the actuator 3 in the X direction.

The main body 2 is provided with a cord 26 extending from the casing 25 to the outside. The cord 26 is electrically connected at one end to an internal circuit including the sensors 21 to 24. The other end of the cord 26 is connected to, for example, a controller that is an output destination of a proximity signal and a separation signal of the switch 1.

In the present embodiment, the main body 2 includes the four sensors of a first sensor 21, a second sensor 22, a third sensor 23, and a fourth sensor 24, serving as the three or more sensors. The four sensors 21 to 24 are arranged in order along the Y direction. In the present embodiment, the first sensor 21, the second sensor 22, the third sensor 23, and the fourth sensor 24 are arranged in order in the positive direction of the Y axis (rightward in Fig. 2) along the facing wall 254 provided in the main body 2. Of the four sensors 21 to 24, two sensors (each pair of the first sensor 21 and the second sensor 22, the second sensor 22 and the third sensor 23, and the third sensor 23 and the fourth sensor 24) adjacent in the Y direction, at least partially face in the Y direction. In the present embodiment, centers of the respective sensors 21 to 24 in the X direction are located at the same position in the X direction.

The first sensor 21 and the fourth sensor 24 are arranged at opposite ends of the four sensors 21 to 24 in the Y direction. The first sensor 21 and the fourth sensor 24 are examples of "end sensors" in the present disclosure. In the following description, the first sensor 21 and the fourth sensor 24 are also referred to as the end sensors.

The second sensor 22 and the third sensor 23 are arranged between the first sensor 21 and the fourth sensor 24 in the Y direction. The second sensor 22 and the third sensor 23 are examples of "intermediate sensors" in the present disclosure. In the following description, the second sensor 22 and the third sensor 23 are also referred to as the intermediate sensors.

Each of the sensors 21 to 24 is configured to be able to detect a magnetic flux generated by at least one of the four magnets 31 to 34. In the present embodiment, the four sensors 21 to 24 are Hall ICs including Hall elements. The Hall IC outputs a signal corresponding to the magnetic flux density of the magnetic flux received by the Hall element. For example, the Hall IC outputs a detection signal when detecting a magnetic flux having a predetermined magnetic flux density or more, and does not output a detection signal when detecting a magnetic flux smaller than the predetermined magnetic flux density. For example, the main body 2 outputs a proximity signal corresponding to a state in which the main body 2 and the actuator 3 are close when detection signals are output from all of the sensors 21 to 24; and the main body 2 outputs a separation signal corresponding to a state in which the main body 2 and the actuator 3 are spaced apart when no detection signal is output from at least one of the four sensors 21 to 24.

Each of the sensors 21 to 24 may face at least one of the four magnets 31 to 34 in the X direction. In the present embodiment, in the X direction, the first sensor 21 faces the first magnet 31, the second sensor 22 faces the second magnet 32, the third sensor 23 faces the third magnet 33, and the fourth sensor 24 faces the fourth magnet 34. In addition, of the surfaces of each of the sensors 21 to 24, an entire surface of a region facing the actuator 3 in the X direction faces a surface of each of the magnets 31 to 34.

In the present embodiment, the first sensor 21 detects the first magnetic flux MF1 emitted from the first magnet 31. The second sensor 22 detects the first magnetic flux MF1 and the second magnetic flux MF2 that converge on the second magnet 32. The third sensor 23 detects the second magnetic flux MF2 and the third magnetic flux MF3 that are emitted from the third magnet 33. The fourth sensor 24 detects the third magnetic flux MF3 converging on the fourth magnet 34.

The center of at least one of the four sensors 21 to 24 in the Y direction is located at a position deviating in the Y direction from the center of each of the magnets 31 to 34 in the Y direction. In Fig. 2, the centers, in the Y direction, of each of the four sensors 21 to 24 and each of the four magnets 31 to 34 are shown by the two-dot chain lines extending in the X direction.

Centers C22 and C23 of the intermediate sensors 22 and 23, respectively, in the Y direction may be located at positions deviating in the Y direction from centers C31 to C34 of the respective magnets 31 to 34 in the Y direction. That is, the centers C22 and C23 of the respective intermediate sensors 22 and 23 in the Y direction may be located at positions deviating in the positive direction or the negative direction of the Y axis from the centers C31 to C34 of the respective magnets 31 to 34 in the Y direction.

In the present embodiment, the center C22 of the second sensor 22 in the Y direction is located at a position deviating from the center C32 of the second magnet 32 in the Y direction toward the third sensor 23 in the Y direction, that is, deviating in the positive direction of the Y axis. The center C23 of the third sensor 23 in the Y direction is located at a position deviating from the center C33 of the third magnet 33 in the Y direction toward the second sensor 22 in the Y direction, that is, deviating in the negative direction of the Y axis. That is, the centers C22 and C23 of all of the intermediate sensors 22 and 23 in the Y direction are located at positions deviating in the Y direction from the centers C31 to C34 of the respective magnets 31 to 34 in the Y direction.

A center C21 of the first sensor 21 in the Y direction is located at the same position as the center C31 of the first magnet 31 in the Y direction. A center C24 of the fourth sensor 24 in the Y direction is located at the same position as the center C34 of the fourth magnet 34 in the Y direction.

Fig. 2 shows distances L1 to L3 in the Y direction each between two sensors of the four sensors 21 to 24 adjacent in the Y direction. Specifically, the distance L1 is the shortest distance between the second sensor 22 and the third sensor 23 in the Y direction. The distance L2 is the shortest distance between the first sensor 21 and the second sensor 22 in the Y direction. The distance L3 is the shortest distance between the third sensor 23 and the fourth sensor 24 in the Y direction. In the present embodiment, the distance L2 and the distance L3 are the same distance.

The distance L1 in the Y direction between the two intermediate sensors 22 and 23 adjacent in the Y direction is smaller than the distances L2 and L3 each between the end sensors 21 and 24 and the respective intermediate sensors 22 and 23, the sensors being adjacent to each other in the Y direction.

With the switch 1 according to the present embodiment, at least one of the sensors 21 to 24 can be disposed at a position with a high magnetic flux density, as compared with a configuration in which the centers C21 to C24 of all of the sensors 21 to 24 in the Y direction are located at positions coinciding with the centers C31 to C34 of the respective magnets 31 to 34 in the Y direction. This makes it possible to detect the magnetic fluxes produced by the magnets 31 to 34 provided in the actuator 3 more reliably than the above configuration when the main body 2 and the actuator 3 come into proximity. Thus, it is possible to provide the switch 1 with both the increase in size of the actuator 3 and the deterioration in detection accuracy restrained.

In addition, with the switch 1 according to the present embodiment, each of the intermediate sensors 22 and 23 can be disposed at a position with a high magnetic flux density, as compared with a configuration in which the centers C22 and C23 of the respective intermediate sensors 22 and 23 in the Y direction are located at positions coinciding with the centers C31 to C34 of the magnets 31 to 34 in the Y direction. This makes it possible to detect the magnetic fluxes produced by the magnets 31 to 34 provided in the actuator 3 more reliably than the above configuration when the main body 2 and the actuator 3 come into proximity. Thus, it is possible to provide the switch 1 with both the increase in size of the actuator 3 and the deterioration in detection accuracy restrained.

In addition, with the switch 1 according to the present embodiment, each of the intermediate sensors 22 and 23 can be disposed at a position with a high magnetic flux density, as compared with a configuration in which the shortest distance L1 between the two intermediate sensors 22 and 23 in the Y direction is larger than the shortest distances L2 and L3 in the Y direction each between the end sensors 21 and 24 and the respective intermediate sensors 22 and 23, the sensors being adjacent to each other in the Y direction. This makes it possible to detect the magnetic fluxes produced by the magnets 31 to 34 provided in the actuator 3 more reliably than the above configuration when the main body 2 and the actuator 3 come into proximity. Thus, it is possible to provide the switch 1 with both the increase in size of the actuator 3 and the deterioration in detection accuracy restrained.

In addition, with the switch 1 according to the present embodiment, the center C22 of the second sensor 22 in the Y direction is located at a position deviating in the Y direction from the center C32 of the second magnet 32 in the Y direction toward the third sensor 23, and the center C23 of the third sensor 23 in the Y direction is located at a position deviating in the Y direction from the center C33 of the third magnet 33 in the Y direction toward the second sensor 22. This makes it possible to dispose each of the intermediate sensors 22 and 23 at a position with a high magnetic flux density, as compared with a configuration in which the centers C22 and C23 of the second sensor 22 and the third sensor 23, respectively, in the Y direction are located at positions other than the above positions. This makes it possible to detect the magnetic fluxes produced by the magnets 31 to 34 provided in the actuator 3 more reliably than the above configuration when the main body 2 and the actuator 3 come into proximity. Thus, it is possible to provide the switch 1 with both the increase in size of the actuator 3 and the deterioration in detection accuracy restrained.

Note that the present disclosure is not limited to the above embodiments, and can be implemented in various other modes. For example, in the above embodiment, the switch 1 is a non-contact door switch; however, the present disclosure is not limited thereto. The switch 1 may be one in which the proximity of the main body and the actuator is detected by the sensors of the main body detecting the magnetic fluxes generated by the magnets provided in the actuator. For example, the switch 1 may be incorporated into a system including a mobile body, and may detect that the mobile body provided with the actuator approaches a disposed place of the main body.

In addition, in the above embodiments, the actuator 3 includes the four magnets 31 to 34; however, the present disclosure is not limited thereto. For example, in addition to the four magnets 31 to 34, the actuator 3 may include an additional magnet that generates a magnetic flux detected by the sensors 21 to 24 provided in the main body 2. That is, the actuator 3 may include a total of five or more magnets that generate the magnetic fluxes detected by the sensors 21 to 24. The additional magnet may be arranged along the Y direction together with the four magnets 31 to 34. At this time, the additional magnet may be disposed in any space between the four magnets 31 to 34, or may be disposed outside the four magnets 31 to 34 in the Y direction.

Further, in the above embodiments, the main body 2 includes the four sensors 21 to 24; however, the present disclosure is not limited thereto. The sensors provided in the main body 2 are only necessary to be able to detect all of the three magnetic fluxes MF1 to MF3 generated by the four magnets 31 to 34. That is, the main body 2 may include three sensors corresponding to the respective magnetic fluxes MF1 to MF3. In addition, five or more sensors may be provided. The number of sensors provided in the main body 2 and the number of magnets provided in the actuator 3 may be the same or different.

In addition, two intermediate sensors (the second sensor 22 and the third sensor 23) are provided in the above embodiment; however, the present disclosure is not limited thereto. One or three or more intermediate sensors may be provided.

In addition, in the above embodiment, the centers C22 and C23 of all of the intermediate sensors 22 and 23 in the Y direction are located at positions deviating from the centers C31 to C34 of the respective magnets 31 to 34 in the Y direction; however, the present disclosure is not limited thereto. When two or more intermediate sensors are provided, the center of at least one of the intermediate sensors in the Y direction may be located at a position deviating in the Y direction from the centers of the respective magnets 31 to 34 in the Y direction.

In addition, in the above embodiment, the center C22 of the second sensor 22 in the Y direction is located at a position deviating in the Y direction from the center C32 of the second magnet 32 in the Y direction toward the third sensor 23; however, the present disclosure is not limited thereto. For example, the center C22 of the second sensor 22 in the Y direction may be located at a position deviating in the Y direction from the center C32 of the second magnet 32 in the Y direction toward the first sensor 21. For example, the center C23 of the third sensor 23 in the Y direction may be located at a position deviating in the Y direction from the center C33 of the third magnet 33 in the Y direction toward the fourth sensor 24.

In addition, in the above embodiment, of the four sensors 21 to 24, two sensors adjacent in the Y direction at least partially face in the Y direction; however, the present disclosure is not limited thereto. Fig. 3 is a sectional view corresponding to Fig. 2, showing a modification of the switch of Fig. 1. For example, a third sensor 23A shown in Fig. 3 is disposed at a position deviating from a first sensor 21A, a second sensor 22, and a fourth sensor 24 in the negative direction of the X axis. The third sensor 23A does not face, in the Y direction, the adjacent second sensor 22 and fourth sensor 24 in the Y direction.

In addition, in the above embodiment, of the four sensors 21 to 24, the centers C22 and C23 of the two intermediate sensors 22 and 23 in the Y direction are located at positions deviating in the Y direction from the centers of the respective magnets 31 to 34 in the Y direction; however, the present disclosure is not limited thereto. For example, as shown in Fig. 3, the center (for example, the center C21 of the first sensor 21A in the Y direction) of at least one of the two end sensors 21A and 24 in the Y direction may be located at a position deviating in the Y direction from the centers C31 to C34 of the respective magnets 31 to 34 in the Y direction.

Any embodiment or modification of the various embodiments or modifications is appropriately combined, thereby becoming possible to achieve the respective effects. In addition, combinations of embodiments, combinations of modifications, or combinations of embodiments and modifications are possible, and combinations of features in different embodiments or modifications are also possible.

While the present disclosure has been fully described in connection with preferred embodiments with reference to the accompanying drawings, various modifications and alterations are apparent to those skilled in the art. It is to be understood that such modifications and alterations are included within the scope of the present disclosure as set forth in the appended claims without departing from the scope thereof.

Various embodiments of the present disclosure have been described above in detail with reference to the drawings, and finally, various aspects of the present disclosure will be described. As one example, reference signs are added in the following description.

According to a first aspect of the present disclosure, provided is a switch including:
a main body; and
an actuator that is capable of being disposed at a detection position that the actuator is close to the main body and faces the main body, in which
the actuator includes a first magnet, a second magnet, a third magnet, and a fourth magnet,
the first magnet, the second magnet, the third magnet, and the fourth magnet are arranged in order along a second direction intersecting a first direction that is a facing direction of the main body and the actuator when the actuator is located at the detection position,
the first magnet, the second magnet, the third magnet, and the fourth magnet are each arranged such that one magnetic pole and another magnetic pole are arranged along the first direction, and that an arrangement of the magnetic poles in the first direction is different from that of an adjacent magnet,
the main body includes three or more sensors configured to be able to detect a magnetic flux generated by at least one of the first magnet, the second magnet, the third magnet, and the fourth magnet,
three or more of the sensors are arranged along the second direction, and
when the actuator is located at the detection position, a center of at least one of three or more of the sensors in the second direction is located at a position deviating in the second direction from a center of each of the first magnet, the second magnet, the third magnet, and the fourth magnet in the second direction.

According to a second aspect of the present disclosure, provided is the switch according to the first aspect, in which
the main body includes, as three or more of the sensors, two end sensors located at opposite ends in the second direction, and one or more intermediate sensors located between the two end sensors in the second direction, and
when the actuator is located at the detection position, a center of each of one or more of the intermediate sensors in the second direction is located at a position deviating in the second direction from the center of each of the first magnet, the second magnet, the third magnet, and the fourth magnet in the second direction.

According to a third aspect of the present disclosure, provided is the switch according to the first or the second aspect, in which
the main body includes, as three or more of the sensors, two end sensors located at opposite ends in the second direction, and two intermediate sensors located between the two end sensors in the second direction, and
a shortest distance in the second direction between the two intermediate sensors adjacent in the second direction is smaller than shortest distances in the second direction each between the end sensors and the respective intermediate sensors, the sensors being adjacent to each other in the second direction.

According to a fourth aspect of the present disclosure, provided is the switch according to any one of the first to the third aspects, in which
the main body includes, as three or more of the sensors, a first sensor, a second sensor, a third sensor, and a fourth sensor that are arranged in order in the second direction,
when the actuator is located at the detection position, in the first direction, the first sensor faces the first magnet, the second sensor faces the second magnet, the third sensor faces the third magnet, and the fourth sensor faces the fourth magnet,
when the actuator is located at the detection position, a center of the second sensor in the second direction is located at a position deviating in the second direction from a center of the second magnet in the second direction toward the third sensor, and
when the actuator is located at the detection position, a center of the third sensor in the second direction is located at a position deviating in the second direction from a center of the third magnet in the second direction toward the second sensor.

### INDUSTRIAL APPLICABILITY

The switch according to the present disclosure restrains both the increase in size of the actuator and the deterioration in detection accuracy, and is therefore useful as various switches, including the switch incorporated into the system, that detect that the actuator provided with the magnets approaches the main body.

### REFERENCE SIGNS LIST

- 1: switch
- 2: main body
- 21, 21A: first sensor
- 22: second sensor
- 23, 23A: third sensor
- 24: fourth sensor
- 3: actuator
- 31: first magnet
- 32: second magnet
- 33: third magnet
- 34: fourth magnet
- 31a, 32a, 33a, 34a: one magnetic pole
- 31b, 32b, 33b, 34b: another magnetic pole

## Claims

1. A switch comprising:
a main body; and
an actuator that is capable of being disposed at a detection position that the actuator is close to the main body and faces the main body, wherein
the actuator includes a first magnet, a second magnet, a third magnet, and a fourth magnet,
the first magnet, the second magnet, the third magnet, and the fourth magnet are arranged in order along a second direction intersecting a first direction that is a facing direction of the main body and the actuator when the actuator is located at the detection position,
the first magnet, the second magnet, the third magnet, and the fourth magnet are each arranged such that one magnetic pole and another magnetic pole are arranged along the first direction, and that an arrangement of the magnetic poles in the first direction is different from that of an adjacent magnet,
the main body includes three or more sensors configured to be able to detect a magnetic flux generated by at least one of the first magnet, the second magnet, the third magnet, and the fourth magnet,
three or more of the sensors are arranged along the second direction, and
when the actuator is located at the detection position, a center of at least one of three or more of the sensors in the second direction is located at a position deviating in the second direction from a center of each of the first magnet, the second magnet, the third magnet, and the fourth magnet in the second direction.

2. The switch according to claim 1, wherein
the main body includes, as three or more of the sensors, two end sensors located at opposite ends in the second direction, and one or more intermediate sensors located between the two end sensors in the second direction, and
when the actuator is located at the detection position, a center of each of one or more of the intermediate sensors in the second direction is located at a position deviating in the second direction from the center of each of the first magnet, the second magnet, the third magnet, and the fourth magnet in the second direction.

3. The switch according to claim 1 or 2, wherein
the main body includes, as three or more of the sensors, two end sensors located at opposite ends in the second direction, and two intermediate sensors located between the two end sensors in the second direction, and
a shortest distance in the second direction between the two intermediate sensors adjacent in the second direction is smaller than shortest distances in the second direction each between the end sensors and the respective intermediate sensors, the sensors being adjacent to each other in the second direction.

4. The switch according to any one of claims 1 to 3, wherein
the main body includes, as three or more of the sensors, a first sensor, a second sensor, a third sensor, and a fourth sensor that are arranged in order in the second direction,
when the actuator is located at the detection position, in the first direction, the first sensor faces the first magnet, the second sensor faces the second magnet, the third sensor faces the third magnet, and the fourth sensor faces the fourth magnet,
when the actuator is located at the detection position, a center of the second sensor in the second direction is located at a position deviating in the second direction from a center of the second magnet in the second direction toward the third sensor, and
when the actuator is located at the detection position, a center of the third sensor in the second direction is located at a position deviating in the second direction from a center of the third magnet in the second direction toward the second sensor.
